(19) 

Europäisches
Patentamt

European
Patent Office

Office européen
des brevets

(11) **EP 4 267 977 B1**

(12) **EUROPEAN PATENT SPECIFICATION**

(45) Date of publication and mention
of the grant of the patent:
**28.01.2026 Bulletin 2026/05**

(21) Application number: **21840343.4**

(22) Date of filing: **14.12.2021**

(51) International Patent Classification (IPC):
*G01R 31/36* $^{(2020.01)}$      *A61N 1/39* $^{(2006.01)}$

(52) Cooperative Patent Classification (CPC):
**G01R 31/3647;** G01R 31/3646; G01R 31/3842

(86) International application number:
**PCT/US2021/063217**

(87) International publication number:
**WO 2022/140107 (30.06.2022 Gazette 2022/26)**

(54) **REMAINING RUNTIME ALGORITHM**

RESTLAUFZEITALGORITHMUS

ALGORITHME DE FONCTIONNEMENT RESTANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.12.2020 US 202063130347 P
17.11.2021 US 202117528437**

(43) Date of publication of application:
**01.11.2023 Bulletin 2023/44**

(73) Proprietor: **Medtronic, Inc.
Minneapolis, Minnesota 55432 (US)**

(72) Inventors:
• **ZHANG, Bo
  Minneapolis, Minnesota 55316 (US)**
• **ARTMANN, Joel B.
  Minneapolis, Minnesota 55432 (US)**
• **JI, Gang
  Minneapolis, Minnesota 55432 (US)**

(74) Representative: **Zimmermann & Partner
Patentanwälte mbB
P.O. Box 330 920
80069 München (DE)**

(56) References cited:
**EP-A1- 1 072 285     WO-A1-96/10858
GB-A- 2 582 347     US-A- 5 600 230**

## Description

FIELD

The present technology is generally related to techniques for battery management. More specifically, the present technology relates to techniques for accurately determining the runtime remaining for a battery.

BACKGROUND

Rechargeable batteries provide power in a wide variety of systems. The full charge capacity of a battery is a measurement of the maximum chemical capacity of a rechargeable battery. Remaining runtime of a rechargeable battery reflects the charge state of a battery. Because knowing the remaining runtime is important to patient safety, there is a general need to determine remaining runtime more accurately during all phases of battery operation.

EP 1 072 285 A1 relates to a battery management system for portable patient worn electronic energy delivery devices, in particular a monitor-defibrillator; a remaining runtime is calculated and can be displayed.

GB 2582347 A relates to estimating a remaining runtime of a battery. WO 96/10858 A1 relates to a smart battery algorithm for reporting battery parameters to an external device. US 5,600,230 A relates to a smart battery providing programmable remaining capacity and run-time alarms based on battery-specific characteristics.

SUMMARY

The invention is defined by the appended claims. Embodiments described herein involved an apparatus comprising a fuel gauge and processing circuitry coupled to the fuel gauge. The processing circuitry can receive, from the fuel gauge, an indicator of remaining battery capacity. The processing circuitry can then calculate remaining battery energy based on the remaining battery capacity and further based on an amount of power expected to be used by a battery load during an expected alarm time. The processing circuitry can calculate remaining runtime, excluding an alarm time, based on the remaining battery energy.

Advantages and additional features of the subject matter of the present disclosure will be set forth in the detailed description which follows, and in part will be readily apparent to those skilled in the art from that description or recognized by practicing the subject matter of the present disclosure as described herein, including the detailed description which follows, the claims, as well as the appended drawings.

It is to be understood that both the foregoing general description and the following detailed description present embodiments of the subject matter of the present disclosure and are intended to provide an overview or framework for understanding the nature and character of the subject matter of the present disclosure as it is claimed. The accompanying drawings are included to provide a further understanding of the subject matter of the present disclosure and are incorporated into and constitute a part of this specification. The drawings illustrate various embodiments of the subject matter of the present disclosure and together with the description explain the principles and operations of the subject matter of the present disclosure. Additionally, the drawings and descriptions are meant to be merely illustrative and are not intended to limit the scope of the claims in any manner.

BRIEF DESCRIPTION OF DRAWINGS

FIG. 1 is a block diagram of a device that includes a battery management system for managing a battery in accordance with embodiments.
FIG. 2 is a block diagram that illustrates a battery management system in accordance with embodiments.
FIG. 3 is a flow diagram of a method that illustrates control logic for battery management in accordance with embodiments.

DETAILED DESCRIPTION

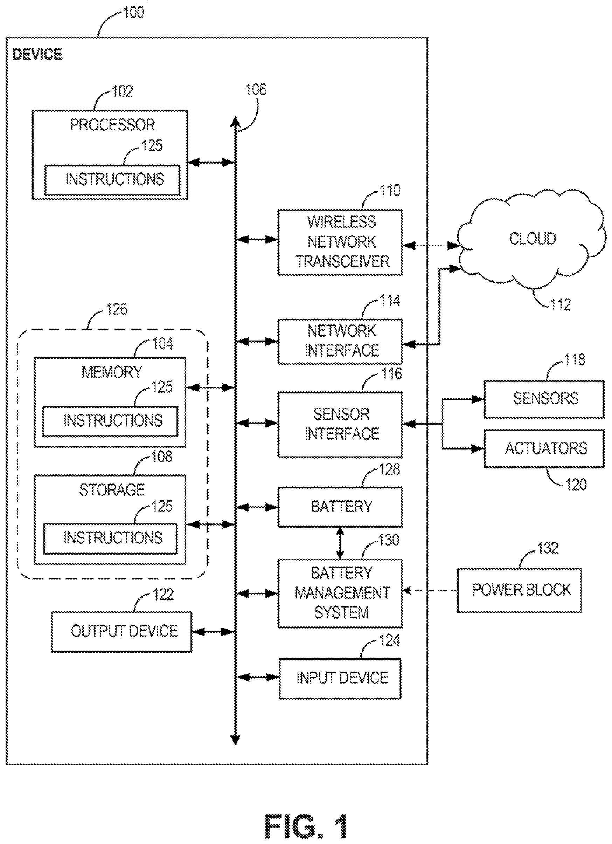

FIG. 1 is a block diagram of a device 100 that includes a battery management system for managing a battery according to operations, processes, methods, and methodologies of embodiments. This device 100 may include any combinations of the hardware or logical components referenced herein. The device 100 can include components of, or be used to control operations of, a ventricular assist device. The device 100 may include or couple with any other device, for example other devices needed for implementation of patient therapies.

The device 100 may include processing circuitry in the form of a processor 102, which may be a microprocessor, a multi-core processor, a multithreaded processor, an ultra-low voltage processor, an embedded processor, or other known processing elements. The processor 102 may be a part of a system on a chip in which the processor 102 and other components described herein are formed into a single integrated circuit.

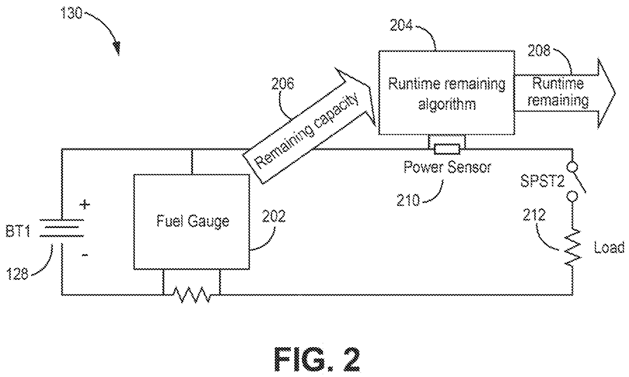

A battery 128 may power the device 100, although, in examples in which the device 100 is in a fixed location, the device 100 may have a power supply coupled to an electrical grid. The battery 128 may be a lithium-ion battery although embodiments are not limited thereto. A battery management apparatus 130 may be included in the device 100 or the battery management apparatus 130 may be part of an external device coupled to the device 100 to track the state of charge (SoC) of the battery 128. A power block 132, or other power supply coupled to a grid, may be coupled with the battery management apparatus 130 to charge the battery 128. In some examples, the power block 132 may be replaced with a wireless power receiver to obtain the power wirelessly. Further detail regarding the battery management apparatus 130 is provided below with reference to FIG. 2.

FIG. 2 is a block diagram that illustrates the battery management apparatus 130 in accordance with embodiments. The battery management apparatus 130 may be used to monitor other parameters of the battery 128 to provide failure predictions, such as the state of health (SoH) and the state of function (SoF) of the battery 128. The battery management apparatus 130 may include battery monitoring circuitry, for example fuel gauge 202, and runtime remaining circuitry 204 to determine runtime remaining in the battery.

Runtime remaining circuitry 204 provides more accuracy to output of the fuel gauge 202 by considering extra energy used for providing alarms and other indicators during low-battery conditions. In embodiments, the runtime remaining circuitry 204 is included on the processor 102 (FIG. 1) of the device 100, although embodiments are not limited thereto. For example, in some embodiments, the fuel gauge 202 can execute some functions of runtime remaining circuitry 204.

Battery 128 capacity corresponds to the quantity of electric charge that can be accumulated during battery 128 charging, stored in open circuit conditions, and released during battery 128 discharge. When the battery 128 is discharged with constant current (e.g., during a discharge cycle according to methods described herein, or during normal operations of the device 100), battery 128 capacity is given by Equation (1):

$$C_d = I \cdot t_d \qquad\qquad (1)$$

where $t_d$ is the discharge duration, and I is current. When discharge duration is expressed in hours, the typical unit for battery 128 capacity is the Ampere-hour (AH).

SoC of the battery 128 indicates voltage at the terminals 214, 216 of that battery 128 when the battery 128 is at rest, or in equilibrium. The mathematical relationship between SoC and equilibrium voltage is a known relationship and is based on battery type. When the battery 128 is not in equilibrium, current is flowing through the battery 128. In this situation, the actual voltage is lower than the equilibrium voltage by an amount that can be calculated using Ohm's Law knowing internal resistance of the battery 128.

Ohm's Law is applied to operation of some fuel gauges such as the fuel gauge 202. The fuel gauge 202 can use Ohm's Law by measuring or the internal resistance of the battery 128 being monitored, multiplying this internal resistance by a measured current to determine an intermediate voltage value, and then offsetting the measured terminal voltage by the intermediate voltage value to obtain an estimate of the equilibrium voltage of the battery 128. Available battery 128 capacity can then be calculated using this estimate of the equilibrium voltage. Other elements and algorithms can be added to improve accuracy of the fuel gauge 202, including Coulomb counters and other apparatuses. The fuel gauge 202 can provide capacity information, voltage information, temperature information, capacity update status, Coulomb count, depth of discharge, error messages, and other information to other systems (e.g., runtime remaining circuitry 204).

The fuel gauge 202 can infer runtime remaining for the battery 128 based on available battery 128 capacity $C_d$ and based on the amount of current drawn by the load 212:

$$time\ remaining = C_d / current\ drawn \qquad\qquad (2)$$

However, the runtime remaining reported by the fuel gauge 202 does not take into consideration the energy required for performing functions that are typically performed during a low-battery situation. Such functions can include, for example, sounding alarms for a fixed amount of time. In addition, the fuel gauge 202 may not account for energy that can be supplied by a power block 132 during low-power conditions or other conditions. Embodiments provide runtime remaining circuitry 204 for more accurate calculation of runtime remaining.

The runtime remaining circuitry 204 takes as an input 206 and indicator of the remaining energy $E_{fg}$ reported by the fuel gauge 202 and gives an output 208 of the runtime remaining $T_{runtime}$. The runtime remaining circuitry 204 can also use a power sensor 210 to measure the average power $P_{avg}$ consumed by the load 212 or averaged through a low-pass filter associated with the power sensor 210 or through a rolling average performed in processor 102. The runtime remaining circuitry 204 determines an amount of energy that will be needed to run the device 100 during an amount of time for which an alarm signal is being transmitted. For example, the runtime remaining circuitry 204 can determine an amount of energy that will be used to run the device 100 for a fixed amount of alarm time. Alarm time may be fixed by the device 100 manufacturer and can signify the amount of time, in seconds or minutes, for which an alarm signal will be provided by the battery 128 during a low-battery condition, before the battery 128 shuts down and the alarm signal is terminated. The runtime remaining circuitry 204 can determine this amount of energy $E_{run}$ by multiplying alarm time by the average load power $P_{avg}$.

Sounding the alarm also requires energy $E_{alarm}$. The final runtime remaining $T_{runtime}$ reported to the user should exclude the alarm time. Next, therefore, runtime remaining circuitry 204 determines the remaining runtime energy $E_{runtime}$ by decrementing by $E_{alarm}$ according to Equation (3):

$$E_{runtime} = E_{fg} - E_{run} - E_{alarm} \qquad (3)$$

The runtime remaining $T_{runtime}$ can be calculated by dividing the runtime energy $E_{runtime}$ by the average load power $P_{avg}$ according to Equation (4):

$$T_{runtime} = E_{runtime}/P_{avg} \qquad (4)$$

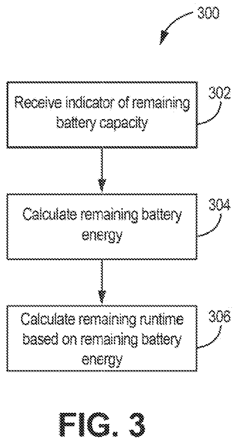

FIG. 3 is a flow diagram of a method 300 for battery management in accordance with embodiments. The method 300 can be implemented by circuitry (e.g., runtime remaining circuitry 204 (FIG. 2)) executing on a processor 102, fuel gauge 202 circuitry (FIG. 2), or other component of a battery management apparatus 130 (FIG. 1 and FIG. 2).

The method 300 can begin with operation 302 with the runtime remaining circuitry receiving an indicator of remaining battery capacity.

The method 300 can continue with operation 304 with the runtime remaining circuitry calculating remaining battery energy based on the remaining battery capacity and further based on an amount of power expected to be used by a battery load during an expected alarm time. The runtime remaining circuitry 204 can decrement the remaining runtime by the expected alarm time. The expected alarm time may be defined as an amount of time for which device 100 is to provide low-energy alarms. The runtime remaining circuitry 204 can decrement the remaining battery energy by an amount of energy used to power the alarm during the expected alarm time. The expected amount of energy providing low-energy alarms may be calculated based on average load power.

The method 300 can continue with operation 306 with the runtime remaining circuitry 204 calculating remaining runtime based on the remaining battery 128 energy. The runtime remaining circuitry 204 can decrement this value for remaining battery 128 energy by an amount of energy used to power the alarm during the expected alarm time.

Referring again to FIG. 1, other components that can be included in the device 100 are described. The processor 102 may communicate with a system memory 104 over an interconnect 106 (e.g., a bus). Any number of memory devices may be used to provide for a given amount of system memory. As examples, the memory 104 may be random access memory (RAM). However, any other type of memory can be included. Persistent storage can also be provided by storage 108. Storage 108 may also couple to the processor 102 via the interconnect 106. Storage 108 may include disk drives, flash memory cards, Universal Serial Bus (USB) flash drives, etc.

The components may communicate over the interconnect 106. The interconnect 106 may include any number of technologies, including industry standard architecture (ISA), extended ISA (EISA), peripheral component interconnect (PCI), peripheral component interconnect extended (PCIx), PCI express (PCIe), or any number of other technologies. The interconnect 106 may be a proprietary bus.

The interconnect 106 may couple the processor 102 to a transceiver 110. The transceiver 110 may use any number of frequencies and protocols, IEEE, or Bluetooth protocols, although embodiments are not limited to these protocols. The transceiver 110 may be included to communicate with devices or services in the cloud 112 via local or wide area network protocols.

A network interface controller (NIC) 114 may be included to provide a wired communication to other devices or systems through the cloud 112. The wired communication may provide an Ethernet connection or may be based on other types of networks. The interconnect 106 may couple the processor 102 to a sensor interface 116 that is used to connect additional devices or subsystems. These additional devices may include sensors 118, such as optical light sensors, camera sensors, temperature sensors, and the like. The interface 116 further may be used to connect the device 100 to actuators 120, such as power switches, valve actuators, an audible sound generator, a visual warning device, and the like.

In some optional examples, various input/output (I/O) devices may be present within or connected to, the device 100. For example, a display or other output device 122 may be included to show information, such as sensor readings, fuel gauge readings, fuel gauge diagnostic outputs, etc. An input device 124, such as a button, touch screen or keypad may be included to accept input. An output device 122 may include any number of forms of audio or visual display, including simple visual outputs such as binary status indicators (e.g., light-emitting diodes (LEDs)) and multi-character visual outputs, or more complex outputs such as display screens (e.g., liquid crystal display (LCD) screens), with the output of characters, graphics, multimedia objects, and the like being generated or produced from the operation of the device 100. A display or console hardware, in the context of the present system, may be used to provide output and receive input of a medical device, including an implantable medical device; to identify a state of a medical device or related/connected devices; or to conduct any other number of management or administration functions.

The storage 108 may include instructions 125 in the form of software, firmware, or hardware commands to implement the techniques described herein. Although such instructions 125 are shown as code blocks included in the memory 104 and the storage 108, it may be understood that any of the code blocks may be replaced with hardwired circuits, for example, built into an application specific integrated circuit (ASIC).

In an example, the instructions 125 provided via the memory 104, the storage 108, or the processor 102 may be embodied as a non-transitory, machine-readable medium 126 including code to direct the processor 102 to perform electronic operations in the device 100. The processor 102 may access the non-transitory, machine-readable medium 126 over the interconnect 106. For instance, the non-transitory, machine-readable medium 126 may be embodied by devices described for the storage 108 or may include specific storage units such as optical disks, flash drives, or any number of other hardware devices. The non-transitory, machine-readable medium 126 may include instructions to direct the processor 102 to perform a specific sequence or flow of actions, for example, as described with respect to the flowchart(s) and block diagram(s) of operations and functionality depicted above. As used herein, the terms "machine-readable medium" and "computer-readable medium" are interchangeable.

In further examples, a machine-readable medium also includes any tangible medium that is capable of storing, encoding, or carrying instructions for execution by a machine and that cause the machine to perform any one or more of the methodologies of the present disclosure or that is capable of storing, encoding or carrying data structures utilized by or associated with such instructions. A "machine-readable medium" thus may include but is not limited to, solid-state memories, and optical and magnetic media. Specific examples of machine-readable media include non-volatile memory, including but not limited to, by way of example, semiconductor memory devices (e.g., electrically programmable read-only memory (EPROM), electrically erasable programmable read-only memory (EEPROM)) and flash memory devices; magnetic disks such as internal hard disks and removable disks; magneto-optical disks; and CD-ROM and DVD-ROM disks. The instructions embodied by a machine-readable medium may further be transmitted or received over a communications network using a transmission medium via a network interface device utilizing any one of several transfer protocols (e.g., Hypertext Transfer Protocol (HTTP)).

A machine-readable medium may be provided by a storage device or other apparatus which is capable of hosting data in a non-transitory format. In an example, information stored or otherwise provided on a machine-readable medium may be representative of instructions, such as instructions themselves or a format from which the instructions may be derived. This format from which the instructions may be derived may include source code, encoded instructions (e.g., in compressed or encrypted form), packaged instructions (e.g., split into multiple packages), or the like. The information representative of the instructions in the machine-readable medium may be processed by processing circuitry into the instructions to implement any of the operations discussed herein. For example, deriving the instructions from the information (e.g., processing by the processing circuitry) may include compiling (e.g., from source code, object code, etc.), interpreting, loading, organizing (e.g., dynamically or statically linking), encoding, decoding, encrypting, unencrypting, packaging, unpackaging, or otherwise manipulating the information into the instructions.

Various aspects disclosed herein may be combined in different combinations than the combinations specifically presented in the description and accompanying drawings. It should also be understood that, depending on the example, certain acts or events of any of the processes or methods described herein may be performed in a different sequence, may be added, merged, or left out altogether (e.g., all described acts or events may not be necessary to carry out the techniques). In addition, while certain aspects of this disclosure are described as being performed by a single module or unit for purposes of clarity, the techniques of this disclosure may be performed by a combination of units or modules associated with, for example, a medical device.

In one or more examples, the described techniques may be implemented in hardware, software, firmware, or any combination thereof. If implemented in software, the functions may be stored as one or more instructions or code on a computer-readable medium and executed by a hardware-based processing unit. Computer-readable media may include non-transitory computer-readable media, which corresponds to a tangible medium such as data storage media (e.g., RAM, ROM, EEPROM, flash memory, or any other medium that can be used to store desired program code in the form of instructions or data structures and that can be accessed by a computer).

Instructions may be executed by one or more processors, such as one or more digital signal processors (DSPs), general purpose microprocessors, application specific integrated circuits (ASICs), field programmable logic arrays (FPGAs), or other equivalent integrated or discrete logic circuitry. Accordingly, the term "processor" as used herein may refer to any of the foregoing structure or any other physical structure suitable for implementation of the described techniques. Also, the techniques could be fully implemented in one or more circuits or logic elements.

# EP 4 267 977 B1

**Claims**

1. An apparatus (130) comprising:

   a fuel gauge;
   a power sensor (210) configured to measure an average power ($P_{avg}$) consumed by a battery load (212); and
   processing circuitry coupled to the fuel gauge (202) and configured to:

   receive, from the fuel gauge (202), an indicator of remaining battery energy ($E_{fg}$);
   calculate an expected amount of energy ($E_{run}$) needed during an expected alarm time based on the average load power ($P_{avg}$);
   calculate remaining runtime energy ($E_{runtime}$) based on the remaining battery energy ($E_{fg}$) and further based on the expected amount of energy ($E_{run}$) needed during the expected alarm time and by decrementing an energy required for sounding the alarm ($E_{alarm}$); and
   calculate remaining runtime ($T_{runtime}$), excluding the expected alarm time, based on the remaining runtime energy ($E_{runtime}$).

2. The apparatus of claim 1, wherein the expected alarm time is an amount of time for which the processing circuitry is to provide alarms.

3. The apparatus of claim 1, wherein the processing circuitry is further configured to provide an indication of the remaining runtime ($T_{runtime}$) to an external display (122).

4. The apparatus of claim 1, wherein the processing circuitry is further configured to calculate the average power ($P_{avg}$) consumed by the battery load (212).

5. The apparatus of claim 1, wherein the expected alarm time is defined based on device specifications of a device (100) incorporating the apparatus (130).

6. A system comprising:

   a fuel gauge (202) to determine remaining battery energy ($E_{fg}$);
   a battery (128) operatively coupled to the fuel gauge (202);
   a power sensor (210) configured to measure an average power ($P_{avg}$) consumed by a battery load (212); and
   a battery management system comprising one or more processors (102) operably coupled to the battery (128) and configured to:

   receive, from the fuel gauge, an indicator of remaining battery energy ($E_{fg}$);
   calculate an expected amount of energy ($E_{run}$) needed during an expected alarm time based on average load power ($P_{avg}$);
   calculate remaining runtime energy ($E_{runtime}$) based on the remaining battery energy ($E_{fg}$) and further based on the expected amount of energy ($E_{run}$) needed during the expected alarm time and by decrementing an energy required for sounding the alarm ($E_{alarm}$); and
   calculate remaining runtime ($T_{runtime}$) based on the remaining runtime energy ($E_{runtime}$).

7. The system of claim 6, further comprising a display (122), and wherein the one or more processors (102) are further configured to provide indication of remaining runtime ($T_{runtime}$) to the display (122).

8. The system of claim 7, wherein the expected alarm time is an amount of time for which the one or more processors (102) are to provide low-energy alarms.

9. The system of claim 6, wherein the one or more processors (102) are further configured to provide an indication of the remaining runtime ($T_{runtime}$) to an external display (122).

10. The system of claim 9, wherein the one or more processors (102) are further configured to calculate the average power ($P_{avg}$) consumed by the battery load (212).

11. The system of claim 6, further comprising an alarm to provide alarm indications during the expected alarm time,

6

wherein the expected alarm time is defined based on device specifications of the system.

**Patentansprüche**

1. Einrichtung (130), umfassend:

   eine Kraftstoffanzeige;
   einen Leistungssensor (210), der dazu ausgelegt ist, eine durchschnittliche Leistung ($P_{avg}$) zu messen, die von einer Batterielast (212) verbraucht wird; und
   eine Verarbeitungsschaltungsanordnung, die mit der Kraftstoffanzeige (202) gekoppelt und zu Folgendem ausgelegt ist:

   Empfangen eines Indikators der verbleibenden Batterieenergie ($E_{fg}$) von der Kraftstoffanzeige (202);
   Berechnen einer erwarteten Menge Energie ($E_{run}$), die während einer erwarteten Alarmzeit benötigt wird, basierend auf der durchschnittlichen Lastleistung ($P_{avg}$);
   Berechnen einer Restlaufzeitenergie ($E_{runtime}$) basierend auf der verbleibenden Batterieenergie ($E_{fg}$) und ferner basierend auf der erwarteten Menge Energie ($E_{run}$), die während der erwarteten Alarmzeit benötigt wird, und durch Dekrementieren einer Energie, die zum Auslösen des Alarms ($E_{alarm}$) benötigt wird; und
   Berechnen der Restlaufzeit ($T_{runtime}$) unter Ausschluss der erwarteten Alarmzeit basierend auf der Restlaufzeitenergie ($E_{runtime}$).

2. Einrichtung nach Anspruch 1, wobei die erwartete Alarmzeit eine Zeitdauer ist, für die die Verarbeitungsschaltungsanordnung Alarme bereitstellen soll.

3. Einrichtung nach Anspruch 1, wobei die Verarbeitungsschaltungsanordnung ferner dazu ausgelegt ist, einem externen Display (122) eine Anzeige der Restlaufzeit ($T_{runtime}$) bereitzustellen.

4. Einrichtung nach Anspruch 1, wobei die Verarbeitungsschaltungsanordnung ferner dazu ausgelegt ist, die durchschnittliche Leistung ($P_{avg}$) zu berechnen, die von der Batterielast (212) verbraucht wird.

5. Einrichtung nach Anspruch 1, wobei die erwartete Alarmzeit basierend auf Vorrichtungsspezifikationen einer Vorrichtung (100) definiert wird, die die Einrichtung (130) umfasst.

6. System, umfassend:

   eine Kraftstoffanzeige (202) zum Bestimmen einer verbleibenden Batterieenergie ($E_{fg}$);
   eine Batterie (128), die mit der Kraftstoffanzeige (202) wirkgekoppelt ist;
   einen Leistungssensor (210), der dazu ausgelegt ist, eine durchschnittliche Leistung ($P_{avg}$) zu messen, die von einer Batterielast (212) verbraucht wird; und
   ein Batteriemanagementsystem, das einen oder mehrere Prozessoren (102) umfasst, die mit der Batterie (128) wirkgekoppelt und zu Folgendem ausgelegt sind:

   Empfangen eines Indikators für die verbleibende Batterieenergie ($E_{fg}$) von der Kraftstoffanzeige;
   Berechnen einer erwarteten Menge Energie ($E_{run}$), die während einer erwarteten Alarmzeit benötigt wird, basierend auf der durchschnittlichen Lastleistung ($P_{avg}$);
   Berechnen einer Restlaufzeitenergie ($E_{runtime}$) basierend auf der verbleibenden Batterieenergie ($E_{fg}$) und ferner basierend auf der erwarteten Menge Energie ($E_{run}$), die während der erwarteten Alarmzeit benötigt wird, und durch Dekrementieren einer Energie, die zum Auslösen des Alarms ($E_{alarm}$) benötigt wird; und
   Berechnen der Restlaufzeit ($T_{runtime}$) basierend auf der Restlaufzeitenergie ($E_{runtime}$).

7. System nach Anspruch 6, ferner umfassend ein Display (122), und wobei der eine oder die mehreren Prozessoren (102) ferner dazu ausgelegt sind, dem Display (122) eine Anzeige der Restlaufzeit ($T_{runtime}$) bereitzustellen.

8. System nach Anspruch 7, wobei die erwartete Alarmzeit eine Zeitdauer ist, für die der eine oder die mehreren Prozessoren (102) niederenergetische Alarme bereitstellen sollen.

9. System nach Anspruch 6, wobei der eine oder die mehreren Prozessoren (102) ferner dazu ausgelegt sind, einem externen Display (122) eine Anzeige der Restlaufzeit (T$_{runtime}$) bereitzustellen.

10. System nach Anspruch 9, wobei der eine oder die mehreren Prozessoren (102) ferner dazu ausgelegt sind, die durchschnittliche Leistung (P$_{avg}$) zu berechnen, die von der Batterielast (212) verbraucht wird.

11. System nach Anspruch 6, ferner umfassend einen Alarm, um während der erwarteten Alarmzeit Alarmanzeigen bereitzustellen, wobei die erwartete Alarmzeit basierend auf Vorrichtungsspezifikationen des Systems definiert wird.

**Revendications**

1. Appareil (130), comprenant :

   une jauge à carburant ;
   un capteur de puissance (210) configuré pour mesurer une puissance moyenne (P$_{avg}$) consommée par une charge de batterie (212) ; et
   des circuits de traitement couplés à la jauge à carburant (202) et configurés pour :

   recevoir, en provenance de la jauge à carburant (202), un indicateur d'énergie de batterie restante (E$_{fg}$) ;
   calculer une quantité d'énergie attendue (E$_{run}$) nécessaire pendant un temps d'alarme attendu sur la base de la puissance de charge moyenne (P$_{avg}$) ;
   calculer l'énergie d'exécution restante (E$_{runtime}$) sur la base de l'énergie de batterie restante (E$_{fg}$) et sur la base de la quantité d'énergie attendue (E$_{run}$) nécessaire pendant temps d'alarme attendu et en décrémentant une énergie nécessaire pour déclencher l'alarme (E$_{alarm}$) ; et
   calculer le temps d'exécution restant (T$_{runtime}$), en excluant le temps d'alarme attendu, sur la base de l'énergie d'exécution restante (E$_{runtime}$).

2. Appareil selon la revendication 1, dans lequel le temps d'alarme attendu est une durée pendant laquelle le circuit de traitement doit fournir des alarmes.

3. Appareil selon la revendication 1, dans lequel le circuit de traitement est en outre configuré pour fournir une indication du temps d'exécution restant (T$_{runtime}$) à un affichage externe (122).

4. Appareil selon la revendication 1, dans lequel le circuit de traitement est en outre configuré pour calculer la puissance moyenne (P$_{avg}$) consommée par la charge de batterie (212).

5. Appareil selon la revendication 1, dans lequel le temps d'alarme attendu est défini sur la base de spécifications de dispositifs d'un dispositif (100) incorporant l'appareil (130).

6. Système comprenant :

   une jauge à carburant (202) pour déterminer l'énergie de batterie restante (E$_{fg}$) ;
   une batterie (128) couplée fonctionnellement à la jauge à carburant (202) ;
   un capteur de puissance (210) configuré pour mesurer une puissance moyenne (P$_{avg}$) consommée par une charge de batterie (212) ; et
   un système de gestion de batterie, comprenant un ou plusieurs processeurs (102), couplé fonctionnellement à la batterie (128) et configuré pour :

   recevoir, de la jauge à carburant, un indicateur de l'énergie de batterie restante (E$_{fg}$) ;
   calculer une quantité d'énergie attendue (E$_{run}$) nécessaire pendant un temps d'alarme attendu sur la base de la puissance de charge moyenne (P$_{avg}$) ;
   calculer l'énergie d'exécution restante (E$_{runtime}$) sur la base de l'énergie de batterie restante (E$_{fg}$) et sur la base de la quantité d'énergie attendue (E$_{run}$) nécessaire pendant temps d'alarme attendu et en décrémentant une énergie nécessaire pour déclencher l'alarme (E$_{alarm}$) ; et
   calculer le temps d'exécution restant (T$_{runtime}$) sur la base de l'énergie d'exécution restante (E$_{runtime}$).

7. Système selon la revendication 6, comprenant en outre un affichage (122), et dans lequel lesdits un ou plusieurs processeurs (102) sont en outre configurés pour fournir une indication du temps d'exécution restant (T$_{runtime}$) à

l'affichage (122).

8. Système selon la revendication 7, dans lequel le temps d'alarme attendu est une durée pendant laquelle lesdits un ou plusieurs processeurs (102) doivent fournir des alarmes à faible énergie.

9. Système selon la revendication 6, dans lequel lesdits un ou plusieurs processeurs (102) sont en outre configurés pour fournir une indication du temps d'exécution restant ($T_{runtime}$) à un affichage externe (122).

10. Système selon la revendication 9, dans lequel lesdits un ou plusieurs processeurs (102) sont en outre configurés pour calculer la puissance moyenne ($P_{avg}$) consommée par la charge de batterie (212).

11. Système selon la revendication 6, comprenant en outre une alarme pour fournir des indications d'alarme pendant le temps d'alarme attendu, dans lequel le temps d'alarme attendu est défini sur la base de spécifications de dispositifs du système.

**FIG. 1**

**FIG. 2**

300

```
┌─────────────────────────┐
│ Receive indicator of    │  302
│ remaining battery       │
│ capacity                │
└─────────────────────────┘
            │
            ▼
┌─────────────────────────┐
│ Calculate remaining     │  304
│ battery energy          │
└─────────────────────────┘
            │
            ▼
┌─────────────────────────┐
│ Calculate remaining     │  306
│ runtime based on        │
│ remaining battery       │
│ energy                  │
└─────────────────────────┘
```

**FIG. 3**

**EP 4 267 977 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1072285 A1
- GB 2582347 A
- WO 9610858 A1
- US 5600230 A